(19) Europäisches Patentamt
European Patent Office
Office européen des brevets

(11) **EP 3 089 888 B1**

(12) **FASCICULE DE BREVET EUROPEEN**

(45) Date de publication et mention
de la délivrance du brevet:
**14.10.2020 Bulletin 2020/42**

(51) Int Cl.:
***B60L 58/16*** (2019.01)

(21) Numéro de dépôt: **14821659.1**

(22) Date de dépôt: **23.12.2014**

(86) Numéro de dépôt international:
**PCT/EP2014/079230**

(87) Numéro de publication internationale:
**WO 2015/101570 (09.07.2015 Gazette 2015/27)**

(54) **PROCÉDÉ, DISPOSITIF ET SYSTÈME D'ESTIMATION DE L'ETAT DE SANTÉ D'UNE BATTERIE D'UN VÉHICULE ÉLECTRIQUE OU HYBRIDE EN CONDITION D'UTILISATION, ET PROCÉDÉ DE CONSTRUCTION D'UN MODÈLE POUR UNE TELLE ESTIMATION**

VERFAHREN, VORRICHTUNG UND SYSTEM ZUR MESSUNG DES INTEGRITÄTSZUSTANDES EINER BATTERIE IN EINEM ELEKTRO- ODER HYBRIDFAHRZEUG WÄHREND DES BETRIEBS UND VERFAHREN ZUR ERSTELLUNG EINES MODELLS FÜR SOLCH EINE MESSUNG

METHOD, DEVICE AND SYSTEM FOR ESTIMATING THE STATE OF HEALTH OF AN ELECTRIC OR HYBRID VEHICLE IN RUNNING CONDITION, AND METHOD FOR BUILDING A MODEL FOR SUCH ESTIMATION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **03.01.2014 FR 1450025**

(43) Date de publication de la demande:
**09.11.2016 Bulletin 2016/45**

(73) Titulaire: **Commissariat à l'Énergie Atomique et aux Énergies Alternatives**
**75015 Paris (FR)**

(72) Inventeurs:
• **BARRE, Anthony**
**F-49520 Combree (FR)**
• **GERARD, Mathias**
**F-38100 Grenoble (FR)**

• **SUARD, Frédéric**
**F-78000 Versailles (FR)**

(74) Mandataire: **Marks & Clerk France**
**Immeuble "Visium"**
**22, avenue Aristide Briand**
**94117 Arcueil Cedex (FR)**

(56) Documents cités:
**EP-A2- 2 597 479       FR-A1- 2 980 274**
**US-A1- 2008 054 848   US-A1- 2013 300 377**

• **XIAOSONG HU, FENGCHUN SUN AND YUAN ZOU: "Estimation of State of Charge of a Lithium-Ion Battery Pack for Electric Vehicles Using an Adaptive Luenberger Observer", ENERGIES, 31 décembre 2010 (2010-12-31), pages 1586-1603, XP002730568,**

**Description**

L'invention porte sur un procédé, sur un dispositif et sur un système d'estimation de l'état de santé d'une batterie d'un véhicule électrique ou hybride. L'invention porte également sur un procédé de construction d'un modèle d'estimation de l'état de santé d'une telle batterie.

L'état de santé, ou niveau de vieillissement, d'une batterie peut être quantifié par différentes variables. Les plus utilisées sont les évolutions de capacité, de résistance ou encore de l'impédance de la batterie étudiée. Un indicateur normalement employé est le SOH (« State Of Health », c'est-à-dire état de santé en anglais), défini par :

$$\frac{capacité\ nominale\ au\ temps\ t}{capacité\ initiale} \times 100\%$$

En variante, le SOH est parfois défini à partir de la résistance de la batterie. Un autre indicateur fréquemment utilisé est la vie restante utile (RUL, de l'anglais « Remaining Useful Life », qui représente la proportion de temps (ou le nombre de cycles par exemple) restant jusqu'à un critère de fin de vie EOL (« End Of Life » en anglais), usuellement défini par un seuil de capacité restante, en pourcentage. Le RUL peut également être appelé SOL (« State Of Life », c'est-à-dire état de vie en anglais).

Quel que soit le paramètre utilisé pour le définir, l'état de santé d'une batterie doit être connu en temps réel par l'utilisateur afin d'éviter le risque d'une défaillance intempestive, ou d'une dégradation inattendue des performances de l'appareil ou machine alimenté par ladite batterie. Cela est particulièrement important dans le cas des batteries des véhicules - et notamment des voitures - électriques ou hybrides. Un calcul direct du SOH par mesure de la capacité ou de la résistance de la batterie est possible en principe, mais nécessite des mesures longues et complexes qui ne peuvent pas être mises en œuvre en temps réel. Quant au RUL/SOL, il ne peut qu'être estimé.

En raison de l'importance technique et économique du problème, de très nombreuses méthodes d'estimation de l'état de santé d'une batterie ont été proposées. Pour une revue de ces méthodes on pourra se rapporter à l'article de A. Barré et al. « A review on lithium-ion battery ageing mechanisms and estimations for automotive applications », Journal of Power Sources 241 (2013) pages 680-689.

Il convient de distinguer le problème de l'estimation de l'état de santé (SOH) avec celui de l'estimation de l'état de charge (SOC, acronyme de l'expression anglaise « State Of Charge »). Ce deuxième problème est plus simple à résoudre, car la tension aux bornes d'une batterie chargée à 100% présente une valeur spécifique qui peut servir de référence. Par contre, il n'est généralement pas possible de déterminer un niveau de vieillissement par une simple mesure de tension. Parmi les méthodes connues d'estimation du SOC on peut citer :

-    l'utilisation d'un circuit équivalent RC dont les paramètres sont déterminés à l'aide d'un procédé adaptatif d'identification, décrite par exemple par l'article de Xiaosong Hu et al. « Estimation of State of Charge of a Lithium-Ion Battery Pack for Electric Vehicles Using an Adaptive Luenberger Observer», Energies 2010, 3, 1586 - 1603;
-    un procédé de filtrage utilisant un observable robuste de type H-infini, voir par exemple US 2013/0300377.

La plupart des solutions existantes traitant le problème de l'estimation du niveau de santé d'une batterie en usage réel, et en particulier sur un véhicule électrique, utilisent un circuit équivalent modélisant la batterie. Les circuits équivalents sont différents d'une proposition à l'autre, suivant les dynamiques et les plages de validité de ces modèles empiriques. En effet, la modélisation d'une batterie par circuit équivalent est très difficile du fait de la complexité des nombreux phénomènes physico-chimiques intervenant dans son vieillissement. D'autre part, cette méthodologie n'est pas suffisamment flexible, car les paramètres d'un circuit équivalent doivent être adaptés pour chaque technologie de batterie. Un autre inconvénient majeur de cette méthodologie est que le modèle d'estimation du niveau de vieillissement reçoit en entrée des variables nécessitant des estimations préalables. Par exemple, l'état de charge et la résistance de la batterie doivent être soit mesurés (ce qui nécessite de nombreux tests spécifiques) soit estimés (ce qui est un problème complexe en soi). Ainsi, ces variables induisent des biais dès l'entrée du modèle, ce qui provoque alors une divergence des résultats dans le temps. Enfin, de tels modèles s'avèrent également non représentatif des usages en conditions réelles car ils sont principalement basés sur des tests en conditions contrôlées (bancs de test), qui ne sont pas tous significatifs des usages réels.

A titre d'exemple on peut citer l'article de B. Saha, K. Goebel, S. Poll et J. Christophersen « Prognostics methods for battery health monitoring using a bayesian framework », IEEE Transactions on instrumentation and measurement 58 (2) (2009) 291-297. La méthode décrite dans cet article utilise un circuit équivalent évolutif, caractérisé par des paramètres dont les valeurs sont estimées par des mesures de spectroscopie d'impédance électrochimique. Des courbes de vieillissement, représentant l'évolution de ces paramètres, sont déterminées « hors ligne » par régression à Vecteurs Pertinents RVM (« Relevance Vector Machine ») ; puis, le modèle évolutif ainsi développé est utilisé dans un processus d'estimation dynamique d'état, du type PF (« Particle Filter »).

D'autres méthodes d'estimation de l'état de santé d'une batterie connues de l'art antérieur utilisent des cartographies de vieillissement définies lors de tests préalables ; voir par exemple le document FR2975188. Ces cartographies associent, par exemple, une résistance mesurée à une prédiction de la capacité de la batterie, ou bien utilisent une tension maximale mesurée et une température pour estimer un état de santé. Cette méthodologie n'est pas adaptable aux conditions réelles. En effet, afin d'être représentative des conditions réelles, une cartographie devrait prendre en compte tous les paramètres pouvant intervenir dans les phénomènes de vieillissement. Or ceux-ci sont trop nombreux et interdépendants pour être effectivement pris en compte, ce qui induit un manque de fiabilité des estimations ainsi obtenues.

L'approche de modélisation physique est également largement répandue dans les problématiques liées à l'estimation du vieillissement des batteries ; voir par exemple US20130030739. Elle consiste à déterminer des équations modélisant l'évolution de l'état de santé d'une batterie. Ces équations sont déterminées pour être en concordance avec des données obtenues sur banc d'essai, mais s'avèrent peu adaptées à la modélisation en conditions réelles, car les phénomènes de dégradations sont très complexes et proviennent de nombreux paramètres interdépendants, ce qui entraîne une modélisation très difficile. De plus ces méthodes ne sont pas applicables en ligne car les calculs demandés sont trop complexes pour la puissance des calculateurs embarqués. Un modèle d'estimation de l'état de santé d'une batterie, qui est applicable en-ligne, est néanmoins connu par FR298027: un tel modèle de prévision du vieillissement se fonde sur des données d'utilisation recommandées par le constructeur et mémorisées comme "profil recommandé". L' état de santé est déterminé à partir des valeurs mémorisées d'intensité de courant et de température pendant le fonctionnement et à partir d'un tel modèle de prévision du vieillissement de la batterie implanté au sein du véhicule.

D'autres méthodes encore utilisent des méthodes d'apprentissage comme les réseaux de neurones et/ou la logique floue à partir de signaux et de paramètres estimés. Voir par exemple le document US 2010/0324848. Ces méthodes peuvent être utilisées en ligne; leurs principaux désavantages sont liés à l'utilisation de données obtenues sur banc de test.

L'invention vise à surmonter, en tout ou en partie, au moins certains des inconvénients précités de l'art antérieur. Plus particulièrement l'invention vise à permettre une estimation fiable et « en ligne » (c'est-à-dire en cours d'utilisation) de l'état de santé d'une batterie d'un véhicule électrique ou hybride.

Un objet de l'invention permettant d'atteindre ce but est un procédé d'estimation de l'état de santé d'une batterie d'un véhicule électrique ou hybride en conditions d'utilisation, selon la revendication 8.

Un autre objet de l'invention est un dispositif d'estimation de l'état de santé d'une batterie d'un véhicule électrique ou hybride en conditions d'utilisation, selon la revendication 15.

Encore un autre objet de l'invention est un procédé de construction d'un modèle d'estimation de l'état de santé d'une batterie d'un véhicule électrique ou hybride en conditions d'utilisation, selon la revendication 1.

D'autres caractéristiques, détails et avantages de l'invention ressortiront à la lecture de la description faite en référence aux dessins annexés donnés à titre d'exemple et qui représentent, respectivement :

- La figure 1, un schéma fonctionnel d'un système d'estimation de l'état de santé d'une batterie d'un véhicule électrique ou hybride selon un mode de réalisation de l'invention ;
- La figure 2, un ordinogramme d'un procédé d'estimation de l'état de santé d'une batterie d'un véhicule électrique ou hybride et d'un procédé de construction d'un modèle pour une telle estimation selon deux modes de réalisation de l'invention ;
- Les figures 3A et 3B, une étape d'extraction de segments de séries temporelles de mesures correspondant à des motifs de vitesse du véhicule satisfaisant à une condition prédéfinie, selon un mode de réalisation de l'invention ;
- La figure 4, la pseudo-métrique de déformation temporelle dynamique (DTW), utilisée dans un mode de réalisation avantageux de l'invention ;
- Les figures 5A et 5B, des segments de séries temporelles de mesures de vitesse et de courant obtenues lors de la mise en œuvre d'un procédé selon un mode de réalisation de l'invention ;
- Les figures 6A, 6B, 6C et 7A, 7B, 7C, des graphiques illustrant une opération (optionnelle) de recalage ; et
- La figure 8, les résultats d'une estimation continue de l'état de santé d'une batterie obtenus en mettant en œuvre un procédé selon un mode de réalisation de l'invention.

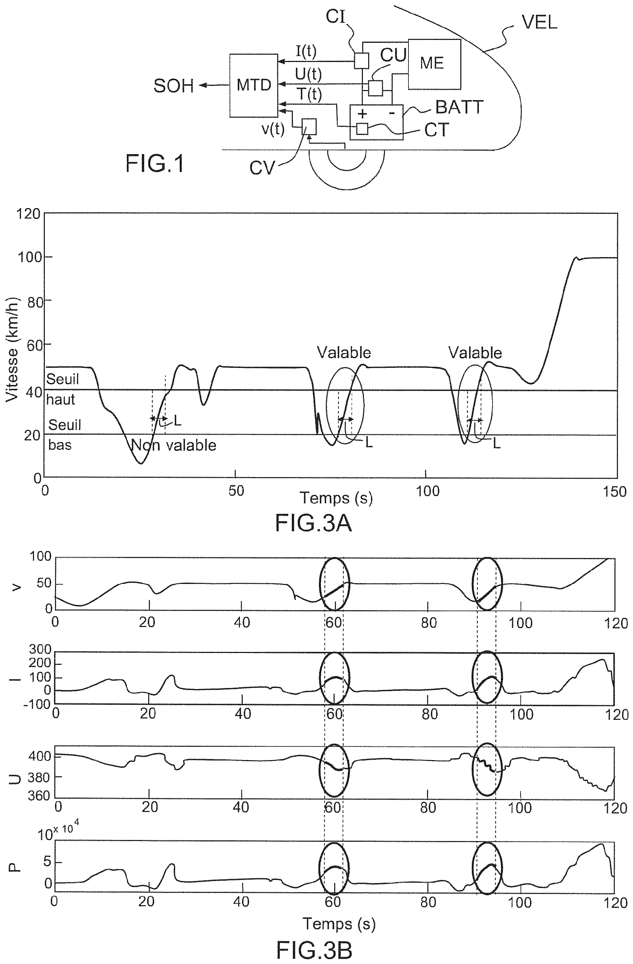

La figure 1 représente une batterie électrique BATT embarquée dans un véhicule terrestre électrique ou hybride VEL, alimentant un moteur électrique ME et connectée à un système d'estimation de son état de santé selon un mode de réalisation de l'invention. Ce système, également embarqué, comprend un module de traitement des données MTD et une pluralité de capteurs, et notamment : un capteur de tension CU pour mesurer la tension $U(t)$ aux bornes de la batterie ; un capteur de courant CI pour mesurer un courant $I(t)$ fourni (ou absorbé) par la batterie, un capteur de température CT pour mesurer une température interne $T(t)$ de la batterie et un capteur de vitesse CV mesurant la vitesse instantanée $v(t)$ du véhicule.. D'autres capteurs peuvent également être présents, notamment d'autres capteurs de température pour mesurer des températures à différents endroits de la batterie ou de son environnement. Inversement, le capteur de température CT et/ou l'un des deux capteurs CU, CI (mais pas les deux à la fois) peuvent être omis. Le capteur de vitesse peut être remplacé ou accompagné par un capteur d'accélération du véhicule, ou du tout autre capteur mesurant un paramètre caractéristique d'un état de mouvement de ce dernier. Le module de traitement des données MTD reçoit en entrée les signaux générés par ces capteurs et fournit en sortie une estimation de l'état de santé de la batterie (indiqué par « SOH » sur la figure, mais il peut s'agir de tout paramètre indicatif d'un tel état de santé, comme par exemple le RUL). Ce module peut notamment comprendre par un processeur programmé de manière opportune, accompagné d'une mémoire stockant un ou plusieurs programmes pour la mise en œuvre d'un procédé selon l'invention, des paramètres d'un ou plusieurs modèles d'estimation de l'état de santé de la batterie et éventuellement des séries temporelles de mesures issues desdits capteurs (ce qui est utile pour la construction et/ou la mise à jour hors ligne des modèles). Il peut également comprendre un ou plusieurs autres circuits, analogiques ou numériques, de traitement des signaux.

Le module de traitement des données MTD, ainsi que tous ou certains des capteurs CI, CU, CT et Cv, peut faire partir d'un système de gestion de batterie (BMS, de l'anglais « Battery Management System »).

Comme cela sera expliqué en détail par la suite, la construction du ou des modèles d'estimation de l'état de santé de la batterie se fait en utilisant à la fois les signaux issus des capteurs CI, CU, CT, Cv et les résultats de caractérisations « hors ligne » de la batterie. Cette construction peut être effectuée par le module de traitement des données MTD (qui doit alors recevoir en entrée les résultats précités) ou par un ordinateur externe, interfacé avec le module MTD.

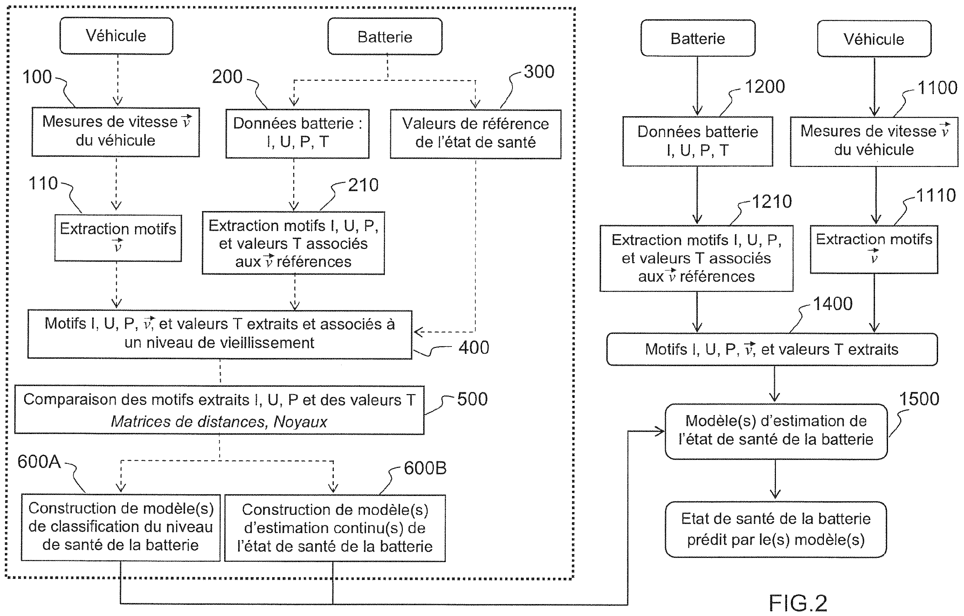

Conformément à l'invention, l'état de santé de la batterie BATT est estimé directement à partir de signaux issus de la batterie et du véhicule, obtenus par l'intermédiaire des capteurs CI, CU, CT, Cv. La figure 2 illustre :

- dans sa partie gauche, un procédé de construction d'un modèle d'estimation de l'état de santé de la batterie BATT ; et
- dans sa partie droite, un procédé d'estimation de l'état de santé de la batterie BATT à partir de ce modèle.

Ces deux procédés constituent deux aspects de la présente invention. Ils utilisent tous deux les signaux générés par les capteurs CI, CU, CT, Cv au cours du fonctionnement réel de la batterie et du véhicule. Le procédé de construction du modèle d'estimation utilise également des valeurs de référence de l'état de santé de la batterie, obtenues par caractérisation « hors ligne ». Le procédé d'estimation de l'état de santé, par contre, est effectué entièrement « en ligne » ou en « temps réel ».

Les différentes étapes de ces deux procédés seront maintenant décrites en faisant référence, lorsque cela sera nécessaire, aux figures 31, 3B et 4.

I. Construction du ou des modèles d'estimation de l'état de santé de la batterie (partie de gauche de la figure 2).

La construction du ou des modèles d'estimation de l'état de santé de la batterie comporte les étapes suivantes : l'obtention, en temps réel, de données relatives à la batterie (courant et/ou tension et/ou puissance, éventuellement température...) et au véhicule (vitesse et/ou accélération), l'extraction de motifs de vitesse de référence, ainsi que de motifs de courant et/ou tension et/ou puissance et de valeurs de température correspondant à ces motifs ; la mise en correspondance de ces motifs avec des valeurs de référence de l'état de santé de la batterie, obtenus par interpolation de mesures effectuées hors-ligne ; la comparaison des motifs extraits, précédée ou accompagnée d'un recalage éventuel ; et enfin la construction proprement dite de modèles d'estimation continue ou discrète (classification) de l'état de santé de la batterie.

i. Obtention des données de la batterie et du véhicule - blocs 100 200 et 300 de l'ordinogramme de la figure 2.

Cette première étape consiste à recueillir directement des données des batteries et de véhicules étudiés. Ces batteries (ou une seule) doivent avoir été utilisées assez longtemps pour l'obtention de données complètes et diverses. Le critère référent est la fin de vie (EOL) de la batterie, usuellement défini, dans le cas des véhicules électriques, comme le moment où une batterie atteint 80% de sa capacité initiale nominale. Pendant cette phase, les batteries doivent être instrumentées permettant alors l'acquisition permanente de données lors des usages (bloc 200), qui pourront ensuite être utilisées dans l'invention. Ces valeurs peuvent être la température T des batteries, la tension U à leurs bornes, le courant délivré I et la puissance délivrée P (cette dernière pouvant être obtenue à partir de mesures de tension et de courant : $P=U\cdot I$).

L'autre variable extraite lors des usages est la vitesse (et/ou l'accélération) des véhicules. Toutes ces acquisitions sont faites au fur et à mesure des essais (bloc 100). Il est suffisant d'avoir au moins un des signaux I, U, P pour établir un modèle prédictif ; toutefois on peut également prendre en compte plusieurs de ces signaux (I, U ou I, P ou U, P ou I, U, P). L'information de la température de chacune des batteries peut elle aussi être ajoutée comme information supplémentaire, mais n'est pas nécessaire à la mise en place du processus.

La construction des modèles étant dans un cadre décentralisé, les données sont conservées, par exemple dans une mémoire du module de traitement MTD, pour être traitées à la fin du processus d'acquisitions de données d'essais réels. Ceci permet alors d'effectuer les calculs au moyen d'un ordinateur autre que le BMS (système de gestion de batterie) qui acquiert les données.

D'autre part, il est nécessaire pour la méthodologie d'avoir des références d'état de santé afin de construire les modèles. Ces références doivent être obtenues périodiquement lors de l'expérimentation (bloc 300). Ceci peut être fait par le biais de caractérisations complètes des batteries étudiées ou du véhicule (tests sur banc à rouleau) ou bien par d'autres procédés : tension à vide, etc. Ces tests permettent l'obtention de paramètres de vieillissement des batteries, par exemple la capacité maximale ou bien la valeur de la résistance de la batterie aux instants des caractérisations. Ces valeurs servent de référence de vieillissement pour la construction des modèles. Une interpolation (linéaire, cubique, etc.) permet d'obtenir une évolution continue de ces valeurs d'état de santé de la batterie. L'axe « temporel » peut être le temps d'expérimentation ou bien l'énergie délivrée, voire la distance selon les variables obtenues lors des tests. On obtient ainsi des évolutions d'état de santé continus pour chacune des batteries ayant été étudiés dans ce processus.

Ainsi, il existe dans ce contexte trois différents types de données dépendants les uns des autres:

- Données des batteries lors de leurs usages : courant instantané I, et/ou tension U et/ou puissance P, et possiblement température T ;
- Données des véhicules lors des roulages : $\bar{v}$ ;
- Evolution de la référence de l'état de santé de chacune des batteries.

Par la suite on notera S l'ensemble des signaux issus de la batterie. Ainsi, S contient au moins un signal parmi (I, U et P) et peut également contenir une information de température T. Par convention on utilisera le pluriel concernant l'ensemble S, bien que ce dernier puisse ne comprendre qu'un seul signal (I ou U ou P).

ii. Extraction des motifs $\bar{v}$ références - bloc 110.

Une idée à la base de la présente invention consiste à comparer les différences entre signaux issus de la batterie au fil du temps afin de prédire le vieillissement subi par la batterie. Pour ce faire, il est nécessaire de prendre un critère de comparaison, afin de quantifier la modification des signaux au fil du temps pour des utilisations identiques ou similaires. Une autre idée à la base de l'invention consiste à extraire, des séries temporelles de mesures issues des capteurs, des motifs répétitifs servant de référence aux comparaisons faites par la suite. Ces comparaisons seront établies dans le but d'identifier les différences de comportement des signaux selon le niveau de vieillissement correspondant à cet instant.

Le signal qui sert de référence est la vitesse du véhicule (dans d'autres modes de réalisation, il pourrait s'agir de l'accélération). Pour procéder à l'extraction de motifs répétitifs, certains critères doivent être fixés afin de procéder à cette détection de manière automatique. Dans le cas d'un signal vitesse, les critères d'extraction peuvent être la longueur du motif, ainsi que des seuils bas et haut de vitesse. Dans ce cas, pour qu'un motif de vitesse soit sélectionné, on exige qu'une variation de vitesse comprise dans une première plage prédéfinie se produise en un intervalle de temps compris dans une seconde plage prédéfinie. Dans l'exemple de la figure 3A on impose qu'une variation de vitesse d'au moins 20 km/h entre une vitesse basse de 20 km/h et une vitesse haute de 40 km/h (première plage) se produise en un temps non supérieur à 2,5 secondes et non inférieur à 3,7 secondes (deuxième plage) ; la limite inférieure de cette plage pourrait être mise à zéro (on considère toutes les accélérations « rapides »), mais une borne inférieure non nulle est utile pour éviter de prendre en compte des signaux issus d'erreurs de mesure. Dans l'exemple de la figure 3A, un véhicule roule à une vitesse de croisière de 50 km/h et subit cinq épisodes de décélération suivie par une accélération qui le ramène à la vitesse de croisière ; puis il accélère jusqu'à une nouvelle vitesse de croisière de 100 km/h. Seules les phases d'accélération sont considérées (ce qui n'est pas une limitation essentielle). La première phase d'accélération est écartée car la variation de 20 km/h à 40 km/h se produit en un temps supérieur à la limite haute de la deuxième plage ; La deuxième et la cinquième phase d'accélération, ainsi que la dernière accélération qui amène le véhicule à une vitesse de 100 km/h sont écartées car la vitesse ne franchit pas le seuil bas de 20 km/h. Par contre, la troisième et la quatrième phase d'accélération satisfont au critère indiqué plus haut.

Le niveau fixé pour les seuils délimitant la plage de variation de vitesse a une influence importante sur la sensibilité et la précision du procédé. Ainsi, un seuil supérieur de vitesse élevé induira un faible nombre de motifs sauvegardés, ce qui pourra amener un modèle moins performant du fait du manque de données. Au contraire, le choix d'une plage de variation trop étroite entraînera l'extraction d'un grand nombre de motifs, mais ces derniers seront trop courts pour contenir des informations significatives sur l'état de santé de la batterie à l'étude. De plus, l'amplitude de la plage de variation de vitesse peut être choisie en accord avec la fréquence d'acquisition des données. De ce fait, une faible fréquence d'acquisition induit une large plage de variation de vitesse afin de pouvoir identifier des dynamiques dans les signaux. Un critère possible consiste à considérer une longueur limite de 20 valeurs par segment extrait, ce qui représente par exemple un segment de 2 secondes pour une fréquence d'acquisition de 10Hz.

Le but de cette extraction étant de caractériser des phénomènes liés aux vieillissements d'une batterie, le motif est préférentiellement adapté à un fort freinage, ou bien à une accélération forte.

D'autres critères que celui mentionné plus haut peuvent être utilisés pour la sélection des motifs ; par exemple on peut exiger que l'accélération du véhicule dépasse un seuil prédéfini.

iii. Extraction des séries temporelles de mesures correspondant aux motifs de vitesse - bloc 210.

Suite au processus d'extraction des motifs de la variable référence (vitesse, voire accélération), il est nécessaire d'extraire des segments correspondant auxdits motifs des séries temporelles de signaux S issus de la batterie. Autrement dit, l'information sur la localisation temporelle des motifs références extraits, dans les signaux $\bar{v}$ complets est utilisée afin d'obtenir des segments ou motifs de l'ensemble S (selon les variables prises en compte) associés aux motifs références (vitesses). Cette étape est illustrée sur la figure 3B, qui montre l'extraction de segments de séries temporelles de courant (I), tension (U) et puissance (P) correspondant aux deux motifs de vitesse identifiés lors de l'étape précédente.

Si la température T de la batterie est utilisée, on peut se limiter à retenir sa valeur moyenne en correspondance des motifs de vitesse extraits. En effet, la température a une dynamique lente par rapport aux autres variables.

A l'issue de cette étape on dispose de n profils de vitesses, associés à n segments de séries temporelles de mesures de chaque variable considérée (I et/ou U et/ou P), et optionnellement de n valeurs moyennes de température T. Il est important de conserver les informations d'emplacements dans le temps d'expérimentation, et de la batterie correspondante.

iv. Prise en compte du niveau de vieillissement - bloc 400

Ensuite, chacun des segments de S ainsi extrait est associé à une ou plusieurs références d'état de santé (capacité, impédance...), préalablement déterminées et stockées (étape I.i et bloc 300 sur la figure 2). On aboutit ainsi à n ensembles de données contenant chacun :

- Un motif $\bar{v}$ référence ;
- Au moins un segment d'une série temporelle de mesures S choisie parmi I, U et P, et optionnellement une valeur T ; et
- Au moins une référence de l'état de santé de la batterie correspondant au(x) segment(s) de S et au motif $\bar{v}$ référence.

v. Comparaison des segments extraits, construction de matrices de distances et, le cas échéant, de noyaux - bloc 500.

L'objectif de cette étape est d'étudier la modification des profils extraits, selon le niveau de vieillissement de la batterie, afin de construire des modèles d'estimation d'état de santé. Cependant, il faut considérer que ces motifs de variables sont sensibles aux altérations dans le motif $\bar{v}$ référence. En effet, pour pouvoir comparer idéalement les segments extraits, il serait nécessaire d'avoir exactement les mêmes motifs références (vitesses), issus des mêmes conditions (température, niveau de charge, vent, conducteur...). Dans un tel cas, les modifications perçues dans les segments de S seraient uniquement dues aux phénomènes de vieillissement. Or, l'obtention de conditions exactement identiques est irréalisable dans le contexte de données en usage réels. Il est donc utile d'utiliser une méthodologie prenant en compte les modifications des motifs références.

Pour ce faire, il peut être envisagé de procéder à un recalage en appliquant des transformations appropriées aux motifs $\bar{v}$ références, de manière à les rendre identiques entre eux, puis d'appliquer ces mêmes transformations - ou des transformations correspondantes - sur les segments de S associés. Un tel procédé de recalage peut alors être effectué par des méthodes d'ondelettes, ou par recalage issu de la déformation temporelle dynamique (DTW, de l'anglais « *Dynamic Time Warping* ») ou bien par simple interpolation des signaux.

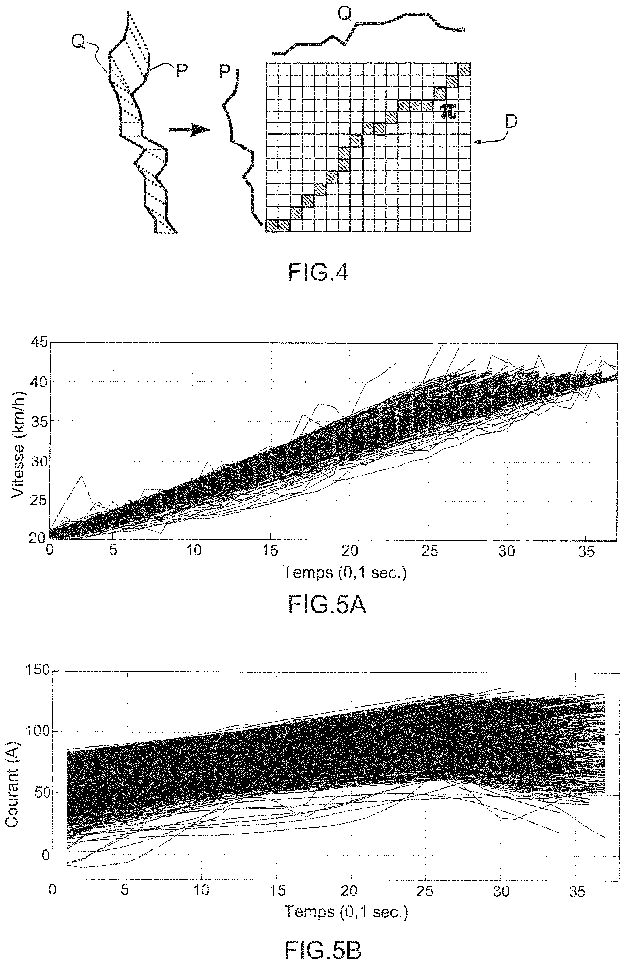

Le principe de la déformation temporelle dynamique sera maintenant illustré à l'aide de la figure 4.

Soient P = $(p_1, ..., p_N)$ et Q = $(q_1, ..., q_M)$ deux séries temporelles de longueurs N et M. Si N≠M, ces deux séries ne peuvent pas être comparées par une simple distance euclidienne. La déformation temporelle dynamique (DTW) permet la contraction et l'expansion de l'axe du temps, atténuant les problèmes d'alignement. Le principe de la métrique DTW (en fait, il s'agit d'une pseudo-métrique) consiste à construire une matrice de coût D (N × M), avec une mesure $\Phi(p_i, q_j)$, souvent définie comme la distance euclidienne $(p_i, q_j) = \|p_i - q_j\|^2$, puis à trouver, parmi l'ensemble des alignements A(N,M) possibles, l'alignement $\pi$ qui minimise les coûts cumulés entre P et Q. Un alignement $\pi$ est de longueur $|\pi|=L$, et est composé de L-tuples $(\pi_1, \pi_2)$, tels que :

$$1 = \pi_1(1) \leq \cdots \leq \pi_1(L) = N$$
$$1 = \pi_2(1) \leq \cdots \leq \pi_2(L) = M$$

Ainsi, on définit la distance DTW entre deux signaux P et Q par:

$$DTW(P, Q) := \min_{\pi \in \mathcal{A}(N,M)} D_{P,Q}(\pi)$$

avec :

$$D_{P,Q} := \sum_{i=1}^{|\pi|} \Phi\big(p_{\pi_1}(i), q_{\pi_2}(i)\big)$$

Comme mentionné plus haut, DTW(P,Q) n'est pas rigoureusement une métrique (on parle de « pseudo-métrique ») car elle ne satisfait pas l'identité triangulaire :

$$DTW(P, R) \not\leq DTW(P, Q) + DTW(Q, R), \forall\, P, Q, R$$

Si la différence de longueur entre les séries temporelles n'est pas trop importante (inférieure à un facteur 2), il est possible d'utiliser une métrique d'alignement global (GA, pour l'anglais « Global Alignement). Une distance GA prend en compte tous les couts

$$D_{P,Q}(\pi),\ \pi \in \mathcal{A}(n, m)\big\}\ ;$$

plus précisément la distance d'alignement global $k_{GA}$ est donnée par

$$k_{GA}(x, y) := \sum_{\pi \in \mathcal{A}(n,m)} exp\big(-D_{x,y}(\pi)\big)$$

Une autre possibilité consiste à ne pas modifier les signaux extraits et d'utiliser un système de comparaison adapté prenant en compte cette problématique. Il s'agit alors de considérer les signaux tels qu'ils ont été extraits, et de les comparer à partir d'une (pseudo)métrique prenant en compte les différences temporelles (par exemple, DTW).

Le recalage par DTW sera maintenant illustré à l'aide d'un exemple.

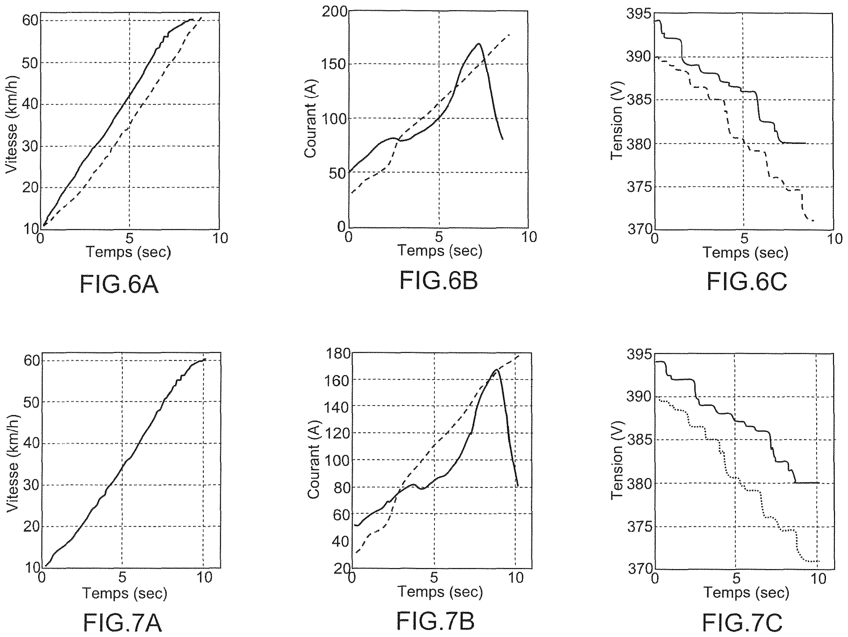

On considère un ensemble S1 de signaux $(V_1, I_1, U_1)$ (en trait plein dans les figures 6A, 6B et 6C) et un autre ensemble S2 de signaux $(V_2, I_2, U_2)$ (en trait pointillé), chacun de ces deux ensembles provenant des mêmes critères d'extraction de vitesses (10-60 km/h entre 7 et 10 secondes). On procède ensuite à un recalage par DTW sur les signaux $V_1$ et $V_2$, en d'autres termes on recherche la transformation $\pi$ décrite plus haut. Pour rappel, cette transformation (ou alignement) met en correspondance les vecteurs $V_1$ et $V_2$ par déformation temporelle. Le processus consiste alors à conserver cette déformation temporelle de l'appliquer directement à I et U. Le résultat de ce procédé est visible sur les figures 7A, 7B et 7C.

Quelle que soit l'option choisie, il est nécessaire d'appliquer une ou plusieurs (pseudo)métriques, afin de quantifier les différences entre segments extraits. Le choix d'une métrique doit permettre la prise en compte des modifications initiales dues aux conditions d'enregistrement des données. La distance euclidienne peut être utilisée dans le cas de segments de longueur identique (ce qui est peu probable dans le cadre d'usage réels). D'autres métriques telles que la distance de Manhattan [Mattausch02], ou bien la « Complexity Invariant Distance » [Batista11] peuvent être employées. D'autres possibilités, n'exigeant pas que les segments soient de longueur identique, sont la distance issue de la DTW [Keogh05] ou bien la corrélation croisée entre signaux [Hirata08], par exemple.

L'avantage particulier de la distance venant de la DTW est qu'elle peut être appliquée quels que soit la longueur ou la forme des segments. De plus, cette méthode permet de calculer la différence entre deux segments en prenant en compte les distorsions temporelles. Ces dernières peuvent, dans le cas étudié ici, être dues aux fluctuations des conditions d'enregistrement (température, pluie, vent, conduite...). Par conséquent l'usage de la DTW semble particulièrement adapté afin de résoudre les problématiques liées aux conditions changeantes.

Chacune de ces métriques fournit une valeur représentant la différence entre deux segments extraits. Il est alors possible d'appliquer une ou plusieurs de ces métriques pour obtenir une (ou des) matrice(s) de dissimilarité entre chacun des segments extraits. Ces matrices quantifiant, de différentes façons, des segments différents, seront employées dans la construction ultérieure des modèles.

Enfin, dans le cadre des constructions de modèles par méthodes statistiques, il peut être choisi de calculer un (des) noyau(x) à partir des métriques calculées précédemment, ou bien directement à partir des segments.

Les noyaux utilisés peuvent être directement issus d'un produit scalaire. Par exemple on peut citer, de manière non limitative :

- Noyau Triangulaire : $K(u) = (1 - |u|)1_{\{|u| \leq 1\}}$ ;

$$K(u) = \frac{1}{\sqrt{2\pi}} e^{-\frac{1}{2}u^2}$$

- Noyau Gaussien :                    ;
- Noyau Epanechnikov : $K(u) = (1 - |u|)1_{\{|u| \leq 1\}}$.
  $u$ correspondant à une distance entre signaux.

Des noyaux calculés à partir de la DTW sont également envisageables. Par exemple on peut citer, de manière non limitative :

- Noyau Gaussien DTW (GDTW) [Lei08] ;
- DTW Negative (NDTW) [Gudmundsson08] ;
- Noyau DTW « Softmax » [De Vries12] ;
- Noyau Gaussien à métrique élastique (GEMK) [Zhang10].

Enfin, des noyaux inspirés de la DTW peuvent également être calculés, tels que ceux issus de l'approche Global Alignment (GA). Par exemple on peut citer, de manière non limitative :

- Noyau d'alignement global (GAK) [Cuturi06] ;
- Noyau « logGA » [Cuturi11] ;
- Noyau GAK triangulaire (TGAK) [Joder08].

Les noyaux directement issus de la DTW ne sont pas, en toute rigueur, définis positifs, bien qu'ils le soient le plus souvent dans les cas applicatifs, car la DTW n'est pas une métrique, mais une pseudo-métrique. Cette caractéristique est la raison de l'approche GA qui tente de résoudre cet inconvénient. Un rapide bilan des différents noyaux est fait dans un article [Joder08].

Chacun de ces noyaux nécessite, pour sa construction, des paramètres, à fixer préalablement, par exemple par validation croisée, qui est une méthode bien connue en statistique. Il peut bien évidement être envisagé d'employer également un autre type de noyau par la suite. De plus, les valeurs de T, si elles ont été prises en compte, peuvent être comparées par un noyau déclinant de la distance euclidienne.

A l'issue de cette étape on dispose donc des n ensembles de données (S, $\overline{v}$, vieillissement) créés lors de l'étape précédente ainsi que des matrices de distance entre les segments de S extraits et éventuellement d'un ou plusieurs noyaux calculés pour chaque variable (U et/ou I et/ou P et/ou T). Toutes ces informations peuvent être utilisées pour de construire des modèles d'estimation de l'état de santé d'une batterie simplement à partir d'au moins un motif extrait de S et d'un motif référence $\overline{v}$ associé.

vi. Construction des modèles - bloc 600A et/ou 600B

Toutes les informations nécessaires extraites par les étapes précédentes forment une base de référence. La dernière étape de cette partie consiste alors à construire des modèles prenant en entrée des segments de S, ainsi qu'optionnellement une valeur T, associés à un motif $\overline{v}$ référence, et qui ont pour sortie une estimation d'état de santé de la batterie correspondante. La sortie peut être discrète ou continue selon le type de méthode utilisée dans la construction de modèle.

600A : Modèle de classification discrète

L'objectif des modèles de classification est de prédire une classe d'état de santé pour un nouveau signal. Ainsi, le résultat de ce type de modèle n'est pas continu, mais discret. De nombreux algorithmes sont adaptés à ce type de problématique. Les classes d'état de santé peuvent être des intervalles, régulières ou non, de valeurs. L'important étant que toutes les valeurs soient contenues dans une et une seule classe.

Voici une liste non-exhaustive des méthodologies les plus proches de la problématique traitée :

- k-Plus Proche Voisins (k-PPV) : Pour un nouveau segment de S fourni en entrée, cette méthode détermine les k segments les plus proches de celui-ci, à partir de la distance prise en compte lors de l'étape précédente. (à partir d'une matrice de distance ou d'un noyau), et attribue le nouveau segment à la classe majoritaire parmi les k voisins. Le seul paramètre à choisir est le nombre de voisins k choisis [Hastie01, p 463-468].
- Moyenne k (kMeans) : Cette méthode forme k clusters de segments pris comme références, chacun associé à la classe d'état de santé majoritaire. La méthodologie de cet algorithme est décrite dans la littérature [Hastie01, p. 460-461]. Ainsi, pour un nouveau segment, sa classe attribuée sera celle du cluster le plus proche. Cette notion peut être définie par la distance moyenne minimale entre le segment à classer et tous les segments d'un cluster, ou bien par la distance entre le segment à classer et le centroïde des segments d'un cluster.
- Classification hiérarchique : De la même façon que la méthode kMeans, ce procédé divise un échantillon de segments références en k clusters. La méthodologie consiste ici à bâtir un arbre hiérarchique à partir des distances calculées lors de l'étape précédente. A partir de cet arbre hiérarchique, l'algorithme consiste à élaguer celui-ci afin de former k clusters de segments. Une fois ces clusters formés, le processus de diagnostic est identique à celui explicité pour la méthode kMeans [Hastie01, p. 520-525].
- Machine à vecteurs support (Support Vector Machine, SVM) : Cette méthode d'apprentissage supervisé, contrairement aux précédentes, requiert une construction de noyau(x) préalable. De plus, elle est la seule pouvant créer un modèle construit sur plusieurs segments issus de S, et également sur un(des) noyau(x) calculé à partir des valeurs de T. Pour ce faire, les noyaux des motifs références sont alors associés (Apprentissage à noyaux multiples, ou MKL de l'anglais « Multiple Kernel Learning »), comme cela est détaillé en [Gonen11]. D'autre part, le processus de fonctionnement complet de la méthode SVM est également décrit dans de nombreux articles tels que [Hastie01, p. 423-431]. Ce procédé permet la détection plus précise des modifications dues aux états de santé changeant de la batterie que ce qui est fourni par les autres méthodes explicitées.

600A : Modèles d'estimation continue

La méthodologie utilisée dans le cadre de l'estimation continue de l'état de santé d'une batterie est principalement basée sur le(s) noyau(x) construit(s) lors de l'étape précédente. De ce fait, si aucun noyau n'a été calculé lors de cette étape, l'estimation continue se fera principalement selon des méthodes de régression.

Les méthodes envisagées pour réaliser une estimation continue de l'état de santé d'une batterie sont, par exemple :

- Méthodes de régression : Des algorithmes de régression, basés sur le « shrinkage », tels que la méthode LASSO [Hastie01, p. 68-69], la méthode Ridge [Hastie01, p. 61-64], ou encore la méthode LARS [Efron03].
- Regression à vecteurs support (Support Vector Regression - SVR) : Cette méthode est une extension des SVM permettant une sortie continue. Le processus est détaillé dans la littérature [Smola03]. Comme dans le cas des SVM, il est possible de prendre en compte plusieurs noyaux, issus de la comparaison des segments de S extraits et des valeurs de T.
- Machine à Vecteurs Pertinents (Relevance Vector Machine (RVM) : Il s'agit de la méthode à noyau la plus usuelle dans les problématiques de sortie continue. Le principe est explicité largement dans [Tipping01]. De la même façon que toutes les méthodes à noyau, l'implémentation de cette méthode nécessite un choix dans les valeurs des paramètres.
- Regression Ridge à noyau (Kernel Ridge Regression) : Une alternative de la régression Ridge consiste à utiliser des noyaux dans cette méthode, comme détaillé dans [Welling].

II. Diagnostic d'une batterie en usage réel (partie de droite de la figure 2)

Cette partie traite de l'application des modèles construits dans la partie I., dans un contexte d'usage réel d'une batterie sur un véhicule électrique ou hybride. Le but est de parvenir à faire un diagnostic de l'état de santé de la batterie, sans besoin d'usage particulier.

Le processus d'estimation de l'état de santé de la batterie utilise de nombreuses étapes décrites en partie I. Ainsi, l'application requiert également une batterie et un véhicule instrumentés, permettant l'acquisition en temps réel des mêmes données que dans la partie I.i. (I et/ou U, et/ou P ; optionnellement T ; $\bar{v}$) - voir les blocs 1200 et 1100 sur la partie droite de la figure 2. De plus, le(s) modèle(s) d'estimation construits lors de l'étape I.vi. sont ici introduits dans la méthodologie sous forme de fonctions de décision de type entrées-sorties.

Le traitement des données obtenues de la batterie consiste dans un premier temps en une extraction, au fur et à mesure des acquisitions, des motifs vitesse correspondant aux critères fixés dans la section I.ii. (blocs 1110 et 1220).

Par la suite, dès qu'un motif vitesse a été extrait (bloc 1400), il peut servir - avec les segments de séries temporelles de S correspondants - pour l'estimation de l'état de santé de la batterie par application d'un ou plusieurs modèles construits lors de l'étape I.vi (bloc 1500). Pour cela, le même processus que celui décrit en I.ii. à I.iv. est appliqué, permettant ainsi l'obtention d'un signal I, U et/ou P correspondant au motif de vitesse extrait (car cela est fait en temps réel pendant les acquisitions). Le cas échéant, un recalage est également appliqué, comme lors de la construction des modèles.

Dans le cas d'une utilisation d'un unique modèle, la réponse obtenue sur l'état de santé de la batterie fournit directement l'estimation. Au contraire, si plusieurs modèles sont utilisés, autant d'estimations sont obtenues. Ainsi, l'utilisateur peut choisir de considérer toutes les estimations (affichage de tous les résultats ce qui forme alors un intervalle de confiance), ou bien de prendre en compte toutes les valeurs afin de calculer un diagnostic d'état de santé à partir des estimateurs. Cela peut consister, entre autres, à calculer une moyenne, une médiane, une sélection des valeurs proches, ou bien de prioriser une méthode

Il est important de noter que ce procédé est mis en œuvre pendant l'utilisation d'un véhicule électrique et en conditions réelles. En effet, les diagnostics sont fournis dès lors qu'un motif de vitesse référence a été détecté, c'est pourquoi la définition de ce dernier est très importante (seuils et longueur du motif). Les estimations sont donc fournies immédiatement après l'extraction d'un motif de vitesse adéquat. En effet, une fois les étapes I. de construction de modèles terminées, les temps de calculs sont compatibles avec un usage embarqué.

Les modèles d'estimation de l'état de santé de la batterie peuvent être mis à jour. Pour cela, il est nécessaire d'obtenir une (ou des) nouvelles valeurs exactes de vieillissement, issues de tests spécifiques. Cela peut alors être effectué lors de tests lors d'un passage du véhicule dans un garage spécialisé.

Deux possibilités permettent alors la mise à jour : soit la construction de nouveaux modèles avec ces données, soit une correction du biais des estimations faites. La première option consiste à reconstruire de nouveaux modèles par le processus explicité lors des étapes I. ; cela nécessite donc une étape hors ligne de calculs. Dans le deuxième cas, il s'agit uniquement d'appliquer une correction aux estimations faites afin de corriger le biais mesuré. Autrement dit, si la dernière estimation faite prédit une résistance de 0,8 et que la valeur exacte mesurée spécifiquement est de 0,81, alors on appliquera un correctif de « + 1,25% » aux nouvelles estimations.

Le résultat technique de l'invention sera maintenant illustré, en considérant un exemple spécifique de mise en œuvre, à l'aide des figures 5A et 5B.

Les critères choisis pour l'extraction des motifs vitesses sont alors une accélération de 20 à 40 km/h entre 2,5 et 3,7 secondes, ce qui correspond aux figures 3A et 3B discutées plus haut. Les motifs obtenus (Figure 5A) illustrent la problématique liée aux décalages dus aux conditions extérieures. On considèrera ici uniquement les signaux de courant afin de faire une estimation de capacité de la batterie. Ces signaux I correspondant aux motifs de vitesse sont présentés sur la figure 5B.

A partir de ces données - et des valeurs de référence de l'état de santé de la batterie - deux modèles sont développés afin de prédire un niveau de capacité rapporté à la capacité initiale (indicateur SOE) : un modèle discret issu de la méthode kNN par distance DTW, un autre à partir de la méthode SVM employant des noyaux logGAK.

Dans le cas de la méthode kNN, une validation croisée permet de fixer à 24 le nombre de plus proches voisins (en terme de distance DTW). On considère les quatre classes suivantes: C1=[100% - 96,75%], C2=[96,75% - 93,50%], C3=[93,50% - 90,25%], C4=[90,25% - 87%]. Les résultats de la méthode sont illustrés par une matrice de confusion, présentant les pourcentages de bonnes classifications, pour une précision globale (pourcentage de signaux dont la classification est exacte) de 59% :

| | | Classe prédite | | | |
|---|---|---|---|---|---|
| | | C1 | C2 | C3 | C4 |
| Classe | C1 | 55.1 % | 28.6 % | 12.2 % | 4.1 % |
| réelle | C2 | 36.7 % | 40.9 % | 16.3 % | 6.1 % |
| | C3 | 19 % | 4.8 % | 66.7 % | 9.5 % |
| | C4 | 6% | 8% | 12 % | 74% |

Une classification SVM a été également effectuée sur ces mêmes données, en considérant deux classes C1'=[100% - 93.50%] et C2'=[93.50% - 87%]. La méthode SVM nécessite elle aussi des paramètres à fixer automatiquement par validation croisée, et plus précisément un paramètre C de marge souple (« soft margin ») et un paramètre $\lambda$ conditionnant la méthode de programmation quadratique (QP) associée . Les résultats permettent alors une précision globale de classification de 80%. La matrice de confusion est :

|  |  | Classe prédite | |
|---|---|---|---|
|  |  | C1' | C2' |
| Classe réelle | C1' | 74.4% | 25.6% |
|  | C2' | 15.1% | 84.9% |

Ainsi, ces deux méthodes fournissent deux classes en résultat. Le choix fait en termes de décision est alors de prendre les moyennes des bornes de ces classes dans le cas où les résultats sont différents. De ce fait lorsque le résultats des estimations à un instant donné sont respectivement C2=[96,75% - 93.50%], et C2'=[93,50% - 87%], on retiendra l'intervalle [95.125%, 90.25%].

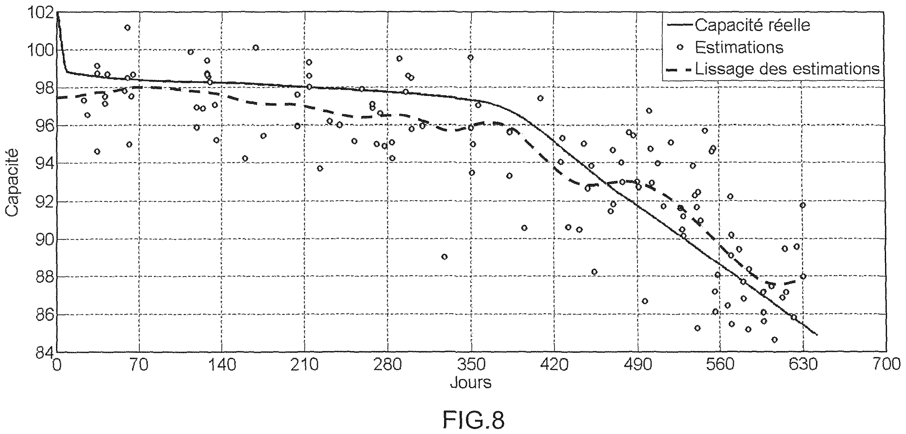

Un modèle d'estimation continue par RVM avec un noyau DTWK a également été testé en utilisant des motifs I et U issus d'accélérations entre 10 et 60 km/h en un temps compris entre 7 et 10 secondes. Les résultats sont illustrés sur la figure 8.

References :

[Batista11] G.E.A.P.A. Batista, X. Wang, E. Keogh, A complexity invariant distance measure for time series, Proceedings of the Eleventh SIAM International Conference on Data Mining, SDM 2011, April 28-30, 2011, Mesa, Arizona, USA.

[Cuturi06] M. Cuturi, J.P. Vert, O. Birkenes, T. Matsui, A kernel for time series based on global alignments, Acoustics, Speech and Signal Processing, 2007. ICASSP 2007, IEEE International Conference on. Vol. 2. IEEE, 2007.

[Cuturi11] M. Cuturi, Fast Global Alignment Kernels, Proceedings of the International Conference on Machine Learning (ICML-11) (2011).

[De Vries12] G. K. D. De Vries, Kernel methods for vessel trajectories (2012) p.45-66.

[Efron03] B. Efron, T. Hastie, I. Johnstone, R. Tibshirani, Least angle regression, Ann.Statist. Volume 32, Number 2 (2004), 407-499.

[Gonen11] M Gönen, E Alpaydin, Multiple kernel learning algorithms, Journal of Machine Learning Research, 999999 (2011): 2211-2268 [Gudmundsson08] S. Gudmundsson, T.P. Runarsson, S. Sigurdsson, Support Vector Machines and Dynamic Time Warping for Time Series, Neural Networks, 2008. IJCNN 2008.(IEEE World Congress on Computational Intelligence). IEEE International Joint Conference on. IEEE, 2008.

[Hastie01] T. Hastie, R. Tibshirani, J. Friedman, The elements of statistical learning, Vol. 2. New York: Springer (2001), p.59-64, 377-384, 412-417,472-479.

[Hirata08] S. Hirata, M.K. Kurosawa, T. Katagiri, Cross-correlation by single-bit signal processing for ultrasonic distance measurement, IEICE Transactions on Fundamentals of Electronics, Communications and Computer Sciences 91.4 (2008): 1031-1037.

[Joder08] C. Joder, S. Essid, G. Richard, Alignment kernels for audio classification with application to music instrument recognition, European Signal Processing Conférence (EUSIPCO 2008), Lausanne, Suisse. 2008.

[Keogh05] E. Keogh, C. A. Ratanamahatana, Exact indexing of dynamic time warping, Knowledge and Information Systems (7) (2005) 358_386.

[Lei08] H. Lei, V. Govindaraju, A Study on the Dynamic Time Warping in Kernel Machines, Signal-Image Technologies and Internet-Based System, 2007. SITIS '07. Third International IEEE Conference on (p. 839-845).

[Mattausch02] H.J. Mattausch, N. Omori, S. Fukae, T. Koide, T. Gyoten, Fully-parallel pattern-matching engine with dynamic adaptability to Hamming or Manhattan distance, VLSI Circuits Digest of Technical Papers 2002. Symposium on, IEEE (2002).

[Smola03] A.J. Smola, B. Schölkopf, A tutorial on support vector regression, Statistics and computing, - 14(3): 199-222.

[Tipping01] M. E. Tipping, Sparse bayesian learning and the relevance vector machine, J. Mach. Learn. Res. 1 (2001) 211_244.

[Welling] M. Welling, Kernel ridge regression Department of Computer Science, University of Toronto, Toronto (Kanada).

[Zhang10] D. Zhang, W. Zuo, D. Zhang, H. Zhang, Time series classification using support vector machine with Gaussian elastic metric kernel, Proceedings of International Conference on Pattern Recognition (2010) IEEE (pp. 29-32).

**Revendications**

**1.** Procédé de construction d'un modèle d'estimation de l'état de santé d'une batterie d'un véhicule électrique ou hybride en conditions d'utilisation, comprenant les étapes suivantes :

A) au cours d'une pluralité de périodes de fonctionnement de ladite batterie, acquérir au moins une série temporelle de mesures de vitesse (v) ou d'accélération dudit véhicule et, simultanément, au moins une série temporelle de mesures (I, U, P) d'au moins une grandeur choisie parmi : un courant délivré par ladite batterie, une puissance délivrée par ladite batterie, ou une tension à ses bornes ;
B) extraire des segments de ladite au moins une série temporelle correspondant à des motifs de vitesse ou d'accélération satisfaisant à au moins une condition prédéfinie ;
C) déterminer des états de santé de référence de ladite batterie au cours desdites périodes de fonctionnement par interpolation d'estimations dudit état de santé obtenues au moyen de caractérisation hors-ligne effectuées entre lesdites périodes de fonctionnement ; et
D) construire au moins un modèle d'estimation continue ou de classification à partir desdits segments de ladite au moins une série temporelle et des états de santé de référence correspondants.

**2.** Procédé selon la revendication 1 dans lequel :

- ladite étape A) comprend également l'acquisition simultanée d'une série temporelle de mesures de température (T) de ladite batterie ;
- ladite étape B) comprend également l'extraction de segments de ladite série temporelle de mesures de température correspondant auxdits motifs de vitesse ou d'accélération ; et
- ladite étape D) comprend la construction dudit modèle d'estimation continue ou de classification également à partir desdits segments de ladite série temporelle de mesures de température, ou d'une valeur moyenne de température associée à chaque dit segment.

**3.** Procédé selon l'une des revendications 1 ou 2 dans lequel, lors de ladite étape B), un segment de ladite série temporelle de mesures de vitesse ou d'accélération satisfait ladite condition prédéfinie lorsqu'une variation de vitesse ou d'accélération, respectivement, comprise dans une première plage prédéfinie se produit en un intervalle de temps compris dans une seconde plage prédéfinie.

**4.** Procédé selon l'une des revendications 1 à 3 dans lequel ladite étape D) comprend une opération de recalage desdits segments desdites séries temporelles de mesures, préalablement à la construction dudit ou de chaque dit modèle d'estimation continue ou de classification, ladite opération de recalage comprenant, pour chaque dit motif de vitesse :

- l'identification d'une transformation convertissant ledit motif de vitesse en un motif de vitesse de référence ; et
- l'application de ladite transformation, ou d'une transformation qui lui est associée, à chaque dit segment desdites séries temporelles correspondant audit motif de vitesse.

**5.** Procédé selon l'une des revendications 1 à 4 dans lequel ledit ou au moins un dit modèle d'estimation continue ou de classification est basé sur une métrique ou pseudo-métrique choisie parmi :

- une pseudo-métrique de déformation temporelle dynamique ; et
- une métrique d'alignement global.

**6.** Procédé selon l'une des revendications 1 à 5 dans lequel ledit ou au moins un dit modèle d'estimation continue ou de classification est un modèle à noyau.

**7.** Modèle d'estimation continue ou de classification, **caractérisé en ce qu'**il est construit conformément au procédé selon l'une des revendications précédentes.

**8.** Procédé d'estimation de l'état de santé d'une batterie (BATT) d'un véhicule électrique ou hybride (VEL) en conditions d'utilisation, comprenant les étapes suivantes :

a) pendant le fonctionnement de ladite batterie, acquérir au moins une série temporelle de mesures de vitesse ou d'accélération (v) dudit véhicule et, simultanément, au moins une série temporelle de mesures d'au moins une grandeur (I, U, P) choisie parmi : un courant délivré par ladite batterie, une puissance délivrée par ladite batterie, et une tension à ses bornes ;

b) extraire des segments de ladite au moins une série temporelle correspondant à des motifs de vitesse ou d'accélération satisfaisant à au moins une condition prédéfinie ; et

c) déterminer au moins une estimation de l'état de santé de ladite batterie par application d'au moins un modèle d'estimation continue ou de classification selon la revendication 7 auxdits segments de ladite au moins une série temporelle.

9. Procédé selon la revendication 8 dans lequel :

- ladite étape a) comprend également l'acquisition simultanée d'une série temporelle de mesures de température (T) de ladite batterie ;
- ladite étape b) comprend également l'extraction de segments de ladite série temporelle de mesures de température correspondant auxdits motifs de vitesse ou d'accélération ; et
- ladite étape c) comprend l'application dudit ou de chaque dit modèle d'estimation continue ou de classification également auxdits segments de ladite série temporelle de mesures de température, ou à une valeur moyenne de température associée à chaque dit segment.

10. Procédé selon l'une des revendications 8 ou 9 dans lequel, lors de ladite étape b), un segment de ladite série temporelle de mesures de vitesse ou d'accélération satisfait ladite condition prédéfinie lorsqu'une variation de vitesse ou d'accélération, respectivement, comprise dans une première plage prédéfinie se produit en un intervalle de temps compris dans une seconde plage prédéfinie.

11. Procédé selon l'une des revendications 8 à 10 dans lequel ladite étape c) comprend une opération de recalage desdits segments desdites séries temporelles de mesures, préalablement à l'application dudit ou de chaque dit modèle d'estimation continue ou de classification, ladite opération de recalage comprenant, pour chaque dit motif de vitesse :

- l'identification d'une transformation convertissant ledit motif de vitesse en un motif de vitesse de référence ; et
- l'application de ladite transformation, ou d'une transformation qui lui est associée, à chaque dit segment desdites séries temporelles correspondant audit motif de vitesse.

12. Procédé selon l'une des revendications 8 à 11 dans lequel ledit ou au moins un dit modèle d'estimation continue ou de classification est basé sur une métrique ou pseudo-métrique choisie parmi :

- une pseudo-métrique de déformation temporelle dynamique ; et
- une métrique d'alignement global.

13. Procédé selon l'une des revendications 8 à 12 dans lequel ledit ou au moins un dit modèle d'estimation continue ou de classification est un modèle à noyau.

14. Procédé selon l'une des revendications 8 à 13 comprenant également une étape d) d'actualisation dudit ou desdits modèles d'estimation continue ou de classification, ou de correction a posteriori desdites estimations, à partir d'estimations de l'état de santé de ladite batterie obtenues par caractérisation hors-ligne.

15. Dispositif d'estimation de l'état de santé d'une batterie (BATT) d'un véhicule électrique ou hybride en conditions d'utilisation, comprenant :

- au moins un premier port d'entrée pour un signal (v) indicatif d'une vitesse ou d'une accélération dudit véhicule ;
- au moins un second port d'entrée pour un signal (I, U, P) indicatif d'un courant ou d'une puissance délivré par ladite batterie, ou d'une tension à ses bornes ; et
- un module de traitement des données (MTD) configuré ou programmé pour mettre en œuvre un procédé selon l'une des revendications 8 à 14 en utilisant lesdits signaux.

16. Système d'estimation de l'état de santé d'une batterie d'un véhicule électrique ou hybride en conditions d'utilisation, comprenant :

- un dispositif selon la revendication 15 ;

- au moins un capteur de vitesse ou d'accélération (Cv) d'un véhicule, relié audit premier port dudit dispositif ; et
- au moins un capteur de courant ou de tension (CI, CU), relié audit second port dudit dispositif.

**Patentansprüche**

1. Verfahren zum Konstruieren eines Modells zum Schätzen des Gesundheitszustands einer Batterie eines Elektro- oder Hybridfahrzeugs unter Betriebsbedingungen, das die folgenden Schritte beinhaltet:

   A) Erfassen, während einer Mehrzahl von Betriebsperioden der Batterie, mindestens einer zeitlichen Serie von Messungen der Geschwindigkeit (v) oder der Beschleunigung des Fahrzeugs und gleichzeitig mindestens einer zeitlichen Serie von Messungen (I, U, P) mindestens einer Größe, die ausgewählt ist aus: einem von der Batterie gelieferten Strom, einer von der Batterie gelieferten Leistung oder einer Spannung an ihren Anschlüssen;
   B) Extrahieren von Segmenten der mindestens einen zeitlichen Serie entsprechend Geschwindigkeits- oder Beschleunigungsmustern, die mindestens eine vordefinierte Bedingung erfüllen;
   C) Bestimmen von Referenzgesundheitszuständen der Batterie während der Betriebsperioden durch Interpolieren von Schätzungen des Gesundheitszustandes, die mittels einer zwischen den Betriebsperioden durchgeführten Offline-Charakterisierung erhalten werden; und
   D) Konstruieren mindestens eines kontinuierlichen Schätz- oder Klassifizierungsmodell aus den Segmenten der mindestens einen zeitlichen Serie und entsprechenden Referenzgesundheitszuständen.

2. Verfahren nach Anspruch 1, wobei:

   - Schritt A) auch das gleichzeitige Erfassen einer zeitlichen Serie von Temperaturmessungen (T) der Batterie beinhaltet;
   - Schritt B) auch das Extrahieren von Segmenten der zeitlichen Serie von Temperaturmessungen beinhaltet, die den Geschwindigkeits- oder Beschleunigungsmustern entsprechen; und
   - Schritt D) die Konstruktion des kontinuierlichen Schätz- oder Klassifizierungsmodells auch aus den Segmenten der zeitlichen Serie von Temperaturmessungen oder aus einem mit jedem Segment assoziierten durchschnittlichen Temperaturwert beinhaltet.

3. Verfahren nach einem der Ansprüch 1 oder 2, wobei in Schritt B) ein Segment der zeitlichen Serie von Geschwindigkeits- oder Beschleunigungsmessungen die vordefinierte Bedingung erfüllt, wenn eine Änderung der Geschwindigkeit bzw. Beschleunigung innerhalb eines ersten vordefinierten Bereichs in einem Zeitintervall innerhalb eines zweiten vordefinierten Bereichs auftritt.

4. Verfahren nach einem der Ansprüche 1 bis 3, wobei Schritt D) einen Schritt des Verschiebens der Segmente der zeitlichen Serien von Messungen vor der Konstruktion des oder jedes kontinuierlichen Schätz- oder Klassifizierungsmodells beinhaltet, wobei der Verschiebungsschritt für jedes der Geschwindigkeitsmuster Folgendes beinhaltet:

   - Identifizieren einer Transformation, die das Geschwindigkeitsmuster in ein Referenzgeschwindigkeitsmuster umwandelt; und
   - Anwenden der Transformation oder einer damit assoziierten Transformation auf jedes Segment der zeitlichen Serien entsprechend dem Geschwindigkeitsmuster.

5. Verfahren nach einem der Ansprüche 1 bis 4, wobei das oder mindestens ein kontinuierliches Schätz- oder Klassifizierungsmodell auf einer Metrik oder Pseudometrik basiert, die ausgewählt ist aus:

   - einer Pseudometrik von dynamischer zeitlicher Verzerrung; und
   - einer globalen Ausrichtungsmetrik.

6. Verfahren nach einem der Ansprüche 1 bis 5, wobei das oder mindestens ein kontinuierliches Schätz- oder Klassifizierungsmodell ein Kernmodell ist.

7. Kontinuierliches Schätz- oder Klassifizierungsmodell, **dadurch gekennzeichnet, dass** es gemäß dem Verfahren nach einem der vorherigen Ansprüche konstruiert ist.

8. Verfahren zur Schätzung des Gesundheitszustandes einer Batterie (BATT) eines Elektro- oder Hybridfahrzeugs (ELV) unter Betriebsbedingungen, das die folgenden Schritte beinhaltet:

   a) Erfassen, während des Betriebs der Batterie, mindestens einer zeitlichen Serie von Geschwindigkeits- oder Beschleunigungsmessungen (v) des Fahrzeugs und gleichzeitig mindestens einer zeitlichen Serie von Messungen mindestens einer Größe (I, U, P), die ausgewählt ist aus: einem von der Batterie gelieferten Strom, einer von der Batterie gelieferten Leistung und einer Spannung an ihren Anschlüssen;
   b) Extrahieren von Segmenten der mindestens einen zeitlichen Serie entsprechend Geschwindigkeits- oder Beschleunigungsmustern, die mindestens eine vordefinierte Bedingung erfüllen; und
   c) Bestimmen mindestens einer Schätzung des Gesundheitszustands der Batterie durch Anwenden mindestens eines kontinuierlichen Schätz- oder Klassifizierungsmodells nach Anspruch 7 auf die Segmente der mindestens einen zeitlichen Serie.

9. Verfahren nach Anspruch 8, wobei:

   - Schritt a) auch das gleichzeitige Erfassen einer zeitlichen Serie von Temperaturmessungen (T) der Batterie beinhaltet;
   - Schritt b) auch das Extrahieren von Segmenten der zeitlichen Serie von Temperaturmessungen entsprechend den Geschwindigkeits- oder Beschleunigungsmustern beinhaltet; und
   - Schritt c) das Anwenden des oder jedes kontinuierlichen Schätz- oder Klassifizierungsmodells auch auf die Segmente der zeitlichen Serie von Temperaturmessungen oder auf einen mit jedem Segment assoziierten mittleren Temperaturwert beinhaltet.

10. Verfahren nach einem der Ansprüche 8 oder 9, wobei in Schritt b) ein Segment der zeitlichen Serie von Geschwindigkeits- oder Beschleunigungsmessungen die vordefinierte Bedingung erfüllt, wenn eine Änderung der Geschwindigkeit bzw. Beschleunigung innerhalb eines ersten vordefinierten Bereichs in einem Zeitintervall innerhalb eines zweiten vordefinierten Bereichs auftritt.

11. Verfahren nach einem der Ansprüche 8 bis 10, wobei Schritt c) einen Schritt des Verschiebens der Segmente der zeitlichen Serien von Messungen vor der Anwendung des oder jedes kontinuierlichen Schätz- oder Klassifizierungsmodells beinhaltet, wobei der Verschiebungsschritt für jedes Geschwindigkeitsmuster Folgendes beinhaltet:

   - Identifizieren einer Transformation, die das Geschwindigkeitsmuster in ein Referenzgeschwindigkeitsmuster umwandelt; und
   - Anwenden der Transformation oder einer damit assoziierten Transformation auf jedes Segment der zeitlichen Serien entsprechend dem Geschwindigkeitsmuster.

12. Verfahren nach einem der Ansprüche 8 bis 11, wobei das oder mindestens ein kontinuierliches Schätz- oder Klassifizierungsmodell auf einer Metrik oder Pseudometrik basiert, die ausgewählt ist aus :

   - einer Pseudometrik von dynamischer Zeitverzerrung; und
   - einer globalen Ausrichtungsmetrik.

13. Verfahren nach einem der Ansprüche 8 bis 12, wobei das oder mindestens ein kontinuierliche(s) Schätz- oder Klassifikationsmodell ein Kernmodell ist.

14. Verfahren nach einem der Ansprüche 8 bis 13, das auch einen Schritt d) des Aktualisierens der ein oder mehreren kontinuierlichen Schätz- oder Klassifizierungsmodelle oder des nachträglichen Korrigierens der Schätzungen anhand von durch Offline-Charakterisierung erhaltenen Schätzungen des Gesundheitszustands der Batterie beinhaltet.

15. Vorrichtung zur Schätzung des Gesundheitszustands einer Batterie (BATT) eines Elektro- oder Hybridfahrzeugs unter Betriebsbedingungen, die Folgendes umfasst:

   - mindestens einen ersten Eingangsport für ein Signal (v), das eine Geschwindigkeit oder eine Beschleunigung des Fahrzeugs anzeigt;
   - mindestens einen zweiten Eingangsport für ein Signal (I, U, P), das einen von der Batterie gelieferten Strom oder eine von der Batterie gelieferte Leistung oder eine Spannung an ihren Anschlüssen anzeigt; und
   - ein Datenverarbeitungsmodul (MTD), konfiguriert oder programmiert zum Implementieren eines Verfahrens nach einem der Ansprüche 8 bis 14 mittels der Signale.

16. System zum Schätzen des Gesundheitszustands einer Batterie eines Elektro- oder Hybridfahrzeugs unter Betriebsbedingungen, das Folgendes umfasst:

- eine Vorrichtung nach Anspruch 15;
- mindestens einen Geschwindigkeits- oder Beschleunigungssensor (Cv) eines Fahrzeugs, verbunden mit dem ersten Port der Vorrichtung; und
- mindestens einen Strom- oder Spannungssensor (CI, CU), der mit dem zweiten Port des Geräts verbunden ist.

**Claims**

1. A method for constructing a model for estimating the state of health of a battery of an electric or hybrid vehicle in conditions of use, comprising the following steps:

A) over a plurality of periods of operation of said battery, acquiring at least one time series of measurements of speed (v) or of acceleration of said vehicle and, simultaneously, at least one time series of measurements (I, U, P) of at least one quantity chosen from: a current delivered by said battery, a power delivered by said battery or a voltage at its terminals;
B) extracting segments of said at least one time series corresponding to speed or acceleration patterns that satisfy at least one predefined condition;
C) determining reference states of health of said battery during said periods of operation by interpolation of estimations of said state of health obtained by means of offline characterization performed between said periods of operation; and
D) constructing at least one continuous estimation or classification model from said segments of said at least one time series and from the corresponding reference states of health.

2. The method according to claim 1, wherein:

- said step A) also comprises the simultaneous acquisition of a time series of measurements of temperature (T) of said battery;
- said step B) also comprises the extraction of segments of said time series of temperature measurements corresponding to said speed or acceleration patterns; and
- said step D) comprises the construction of said continuous estimation or classification model, also from said segments of said time series of temperature measurements, or from a mean temperature value associated with each said segment.

3. The method according to one of claims 1 or 2, wherein, during said step B), a segment of said time series of speed or acceleration measurements satisfies said predefined condition when a variation of speed or of acceleration, respectively, lying within a first predefined range, occurs in a time interval lying within a second predefined range.

4. The method according to one of the claims 1 to 3, wherein said step D) comprises an operation of readjustment of said segments of said time series of measurements, prior to the construction of said or each said continuous estimation or classification model, said readjustment operation comprising, for each said speed pattern:

- the identification of a transformation converting said speed pattern into a reference speed pattern; and
- the application of said transformation, or of a transformation which is associated with it, to each said segment of said time series corresponding to said speed pattern.

5. The method according to one of claims 1 to 4, wherein said or at least one said continuous estimation or classification model is based on a metric or pseudo-metric chosen from:

- a pseudo-metric of dynamic time warping; and
- a metric of overall alignment.

6. The method according to one of claims 1 to 5, wherein said or at least one said continuous estimation or classification model is a kernel model.

7. A continuous estimation or classification model, **characterized in that** it is constructed according to the method according to one of the preceding claims.

8. A method for estimating the state of health of a battery (BATT) of an electric or hybrid vehicle (VEL) in conditions of use, comprising the following steps:

   a) during the operation of said battery, acquiring at least one time series of measurements of speed or of acceleration (v) of said vehicle and, simultaneously, at least one time series of measurements of at least one quantity (I, U, P) chosen from: a current delivered by said battery, a power delivered by said battery and a voltage at its terminals;
   b) extracting segments of said at least one time series corresponding to speed or acceleration patterns that satisfy at least one predefined condition; and
   c) determining at least one estimation of the state of health of said battery by application of at least one continuous estimation or classification model according to claim 7 to said segments of said at least one time series.

9. The method according to claim 8, wherein:

   - said step a) also comprises the simultaneous acquisition of a time series of measurements of temperature (T) of said battery;
   - said step b) also comprises the extraction of segments of said time series of temperature measurements corresponding to said speed or acceleration patterns; and
   - said step c) comprises the application of said or each said continuous estimation or classification model also to said segments of said time series of temperature measurements, or to a mean temperature value associated with each said segment.

10. The method according to one of claims 8 or 9, wherein, during said step b), a segment of said time series of speed or acceleration measurements satisfies said predefined condition when a variation of speed or of acceleration, respectively, lying within a first predefined range occurs in a time interval lying within a second predefined range.

11. The method according to one of claims 8 to 10, wherein said step c) comprises an operation of readjustment of said segments of said time series of measurements, prior to the application of said or each said continuous estimation or classification model, said readjustment operation comprising, for each said speed pattern:

   - the identification of a transformation converting said speed pattern into a reference speed pattern; and
   - the application of said transformation or of a transformation which is associated with it, to each said segment of said time series corresponding to said speed pattern.

12. The method according to one of claims 8 to 11, wherein said or at least one said continuous estimation or classification model is based on a metric or pseudo-metric chosen from:

   - a pseudo-metric of dynamic time warping; and
   - a metric of overall alignment.

13. The method according to one of claims 8 to 12, wherein said or at least one said continuous estimation or classification model is a kernel model.

14. The method according to one of claims 8 to 13, also comprising a step d) of updating of said continuous estimation or classification model or models, or of a posteriori correction of said estimations, from estimations of the state of health of said battery obtained by offline characterization.

15. A device for estimating the state of health of a battery (BATT) of an electric or hybrid vehicle in conditions of use, comprising:

   - at least one first input port for a signal (v) indicative of a speed or of an acceleration of said vehicle;
   - at least one second input port for a signal (I, U, P) indicative of a current or of a power delivered by said battery, or of a voltage at its terminals; and
   - a data processing module (MTD) configured or programmed to implement a method according to one of claims 8 to 14 by using said signals.

**16.** A system for estimating the state of health of a battery of an electric or hybrid vehicle in conditions of use, comprising:

- a device according to claim 15;
- at least one sensor of speed or acceleration (Cv) of a vehicle, linked to said first port of said device; and
- at least one current or voltage sensor (CI, CU), linked to said second port of said device.

FIG.1

FIG.3A

FIG.3B

EP 3 089 888 B1

Véhicule

Batterie

Batterie

Véhicule

100

Mesures de vitesse $\vec{v}$ du véhicule

200

Données batterie : I, U, P, T

300

Valeurs de référence de l'état de santé

1200

Données batterie I, U, P, T

1100

Mesures de vitesse $\vec{v}$ du véhicule

110

Extraction motifs $\vec{v}$

210

Extraction motifs I, U, P, et valeurs T associés aux $\vec{v}$ références

1210

Extraction motifs I, U, P, et valeurs T associés aux $\vec{v}$ références

1110

Extraction motifs $\vec{v}$

Motifs I, U, P, $\vec{v}$, et valeurs T extraits et associés à un niveau de vieillissement

400

1400

Motifs I, U, P, $\vec{v}$, et valeurs T extraits

Comparaison des motifs extraits I, U, P et des valeurs T
*Matrices de distances, Noyaux*

500

600A

Construction de modèle(s) de classification du niveau de santé de la batterie

600B

Construction de modèle(s) d'estimation continu(s) de l'état de santé de la batterie

1500

Modèle(s) d'estimation de l'état de santé de la batterie

Etat de santé de la batterie prédit par le(s) modèle(s)

FIG.2

FIG.4

FIG.5A

FIG.5B

FIG.6A

FIG.6B

FIG.6C

FIG.7A

FIG.7B

FIG.7C

FIG.8

## RÉFÉRENCES CITÉES DANS LA DESCRIPTION

### Documents brevets cités dans la description

- US 20130300377 A
- FR 2975188
- US 20130030739 A
- FR 298027
- US 20100324848 A

### Littérature non-brevet citée dans la description

- **A. BARRÉ et al.** A review on lithium-ion battery ageing mechanisms and estimations for automotive applications. *Journal of Power Sources,* 2013, vol. 241, 680-689
- **XIAOSONG HU et al.** Estimation of State of Charge of a Lithium-Ion Battery Pack for Electric Vehicles Using an Adaptive Luenberger Observer. *Energies,* 2010, vol. 3, 1586-1603
- **B. SAHA ; K. GOEBEL ; S. POLL ; J. CHRISTO-PHERSEN.** Prognostics methods for battery health monitoring using a bayesian framework. *IEEE Transactions on instrumentation and measurement,* 2009, vol. 58 (2), 291-297
- **G.E.A.P.A. BATISTA ; X. WANG ; E. KEOGH.** A complexity invariant distance measure for time series. *Proceedings of the Eleventh SIAM International Conference on Data Mining, SDM,* 28 Avril 2011
- A kernel for time series based on global alignments, Acoustics, Speech. **M. CUTURI ; J.P. VERT ; O. BIRKENES ; T. MATSUI.** Signal Processing, 2007. ICASSP 2007, IEEE International Conference on. IEEE, 2007, vol. 2
- **M. CUTURI.** *Fast Global Alignment Kernels, Proceedings of the International Conference on Machine Learning (ICML-11),* 2011
- **G. K. D. DE VRIES.** *Kernel methods for vessel trajectories,* 2012, 45-66
- **B. EFRON ; T. HASTIE ; I. JOHNSTONE ; R. TIB-SHIRANI.** Least angle regression. *Ann.Statist.,* 2004, vol. 32 (2), 407-499
- **M GÖNEN ; E ALPAYDIN.** Multiple kernel learning algorithms. *Journal of Machine Learning Research,* 2011, vol. 999999, 2211-2268
- Support Vector Machines and Dynamic Time Warping for Time Series, Neural Networks, 2008. IJCNN 2008. **S. GUDMUNDSSON ; T.P. RUNARSSON ; S. SIGURDSSON.** IEEE World Congress on Computational Intelligence). IEEE International Joint Conference on. IEEE, 2008
- **T. HASTIE ; R. TIBSHIRANI ; J. FRIEDMAN.** The elements of statistical learning. Springer, 2001, vol. 2, 59-64, 377-384, 412-417, 472-479
- **S. HIRATA ; M.K. KUROSAWA ; T. KATAGIRI.** Cross-correlation by single-bit signal processing for ultrasonic distance measurement, IEICE Transactions on Fundamentals of Electronics. *Communications and Computer Sciences,* 2008, vol. 91.4, 1031-1037
- **C. JODER ; S. ESSID ; G. RICHARD.** Alignment kernels for audio classification with application to music instrument recognition. *European Signal Processing Conférence (EUSIPCO 2008),* 2008
- **E. KEOGH ; C. A. RATANAMAHATANA.** Exact indexing of dynamic time warping. *Knowledge and Information Systems,* 2005, vol. 7
- **H. LEI ; V. GOVINDARAJU.** A Study on the Dynamic Time Warping in Kernel Machines, Signal-Image Technologies and Internet-Based System. *SITIS '07. Third International IEEE Conference on,* 2007, 839-845
- **H.J. MATTAUSCH ; N. OMORI ; S. FUKAE ; T. KOIDE ; T. GYOTEN.** Fully-parallel pattern-matching engine with dynamic adaptability to Hamming or Manhattan distance, VLSI Circuits Digest of Technical Papers 2002. *Symposium on, IEEE,* 2002
- **A.J. SMOLA ; B. SCHÖLKOPF.** *A tutorial on support vector regression, Statistics and computing,* vol. 14 (3), 199-222
- **M. E. TIPPING.** Sparse bayesian learning and the relevance vector machine. *J. Mach. Learn. Res.,* 2001, vol. 1, 211-244
- **M. WELLING.** Kernel ridge regression Department of Computer Science. University of Toronto
- Time series classification using support vector machine with Gaussian elastic metric kernel. **D. ZHANG ; W. ZUO ; D. ZHANG ; H. ZHANG.** Proceedings of International Conference on Pattern Recognition. IEEE, 2010, 29-32